# EUROPEAN PATENT APPLICATION

(11) **EP 4 629 765 A1**
(43) Date of publication of application: **08.10.2025**
(21) Application number: 24769699.0
(22) Date of filing: 06.02.2024
(51) Int. Cl.: H05K 7/20

(54) **HEAT DISSIPATION STRUCTURE AND ELECTRONIC DEVICE**

(30) Priority: 16.03.2023 CN 202310280857
(71) Applicant: Huawei Technologies Co., Ltd., Shenzhen, Guangdong 518129 (CN)
(72) Inventor: LUO, Yang, Shenzhen, Guangdong 518129 (CN); CHEN, Qiu, Shenzhen, Guangdong 518129 (CN); LIU, Yonglu, Shenzhen, Guangdong 518129 (CN); JIN, Linfang, Shenzhen, Guangdong 518129 (CN)
(74) Representative: Gill Jennings & Every LLP
(86) International application number: PCT/CN2024/076324
(87) International publication number: WO 2024/188003

(57) **Abstract**

Embodiments of this application relate to the field of heat dissipation technologies, and provide a heat dissipation structure and an electronic device, to resolve a problem of severe localized heating in an electronic device in a related technology. The heat dissipation structure includes a first cover plate, a second cover plate, and a liquid-absorbing structure. The first cover plate and the second cover plate are connected to each other to form a receptacle. The liquid-absorbing structure is located in the receptacle. The first cover plate includes a first sealing layer, a first material layer, and a second sealing layer; the first material layer is located between the first sealing layer and the second sealing layer; the first cover plate has a plurality of buffer grooves spaced apart; and positions that are in the first material layer and that correspond to the buffer grooves include elastic deformation. The heat dissipation structure may be applied to an electronic device, to alleviate a problem of severe localized heating in the electronic device and protect a screen.

## Description

This application claims priority to Chinese Patent Application No. 202310280857.2, filed with the China National Intellectual Property Administration on March 16, 2023 and entitled "HEAT DISSIPATION STRUCTURE AND ELECTRONIC DEVICE", which is incorporated herein by reference in its entirety.

### TECHNICAL FIELD

Embodiments of this application relate to the field of heat dissipation technologies, and in particular, to a heat dissipation structure and an electronic device.

### BACKGROUND

An electronic device, such as a mobile phone, a tablet computer, or a notebook computer, generates heat during work. If the heat is not promptly dissipated but accumulates in a local area of the electronic device, a temperature of the local area of the electronic device increases. Consequently, performance of the electronic device and user experience are affected. In severe cases, a fault and damage may be caused to the electronic device. Therefore, a heat dissipation solution needs to be provided to resolve a heat dissipation problem of the electronic device.

### SUMMARY

An objective of embodiments of this application is to provide a heat dissipation structure and an electronic device, so as to resolve a problem of severe localized heating in an electronic device in a related technology.

To achieve the foregoing objective, embodiments of this application provide the following solutions.

According to one aspect, a heat dissipation structure is provided and includes a first cover plate, a second cover plate, and a liquid-absorbing structure. The first cover plate and the second cover plate are connected to each other to form a receptacle. The liquid-absorbing structure is located in the receptacle. The heat dissipation structure has a first area and a second area; and the liquid-absorbing structure extends from the first area to the second area. A vapor channel is further provided in the receptacle, and the vapor channel extends from the second area to the first area. The first cover plate includes a first sealing layer, a first material layer, and a second sealing layer; the first material layer is located between the first sealing layer and the second sealing layer; the first cover plate has a plurality of buffer grooves spaced apart; and positions that are in the first material layer and that correspond to the buffer grooves include elastic deformation.

The heat dissipation structure provided in embodiments of this application can promptly dissipate heat generated by a heat emitting component, so that a problem of severe localized heating is not likely to occur in an electronic device. This can alleviate problems caused by overheating in a local area, such as performance degradation and shortened service life of components in the area, as well as screen burning and impact on display effect. In addition, because the first cover plate has the plurality of buffer grooves, and the plurality of buffer grooves are spaced apart, the first cover plate has excellent buffering and supporting functions. The first cover plate includes the first sealing layer, the first material layer, and the second sealing layer; the first material layer is sandwiched between the first sealing layer and the second sealing layer; and the positions that are in the first material layer and that correspond to the buffer grooves include elastic deformation. Therefore, the buffer grooves of the first cover plate have better stress absorption and release capabilities, and compression deformation and restoration capabilities of the first cover plate can be further improved. For example, when the heat dissipation structure is applied to the foregoing electronic device, for example, when the heat dissipation structure is compressed by the foregoing screen, because the first cover plate has excellent buffering and supporting functions, and the buffer grooves have better stress absorption and release capabilities, the first cover plate has better flexibility. In addition, because the first material layer constrained by the first sealing layer and the second sealing layer does not have excessive rebound force, screen failure problems such as shadows, dark spots, imprints, bright spots, green lines, or shattering caused by excessive rebound force of the first cover plate are not likely to occur.

In addition, because the first sealing layer and the second sealing layer are respectively provided on two opposite sides of the first material layer, on one hand, the first material layer can be sealed and protected well, thereby prolonging service life of the first cover plate and enhancing reliability of the first cover plate; and on the other hand, because a relatively symmetric structure can be formed, flatness of the first cover plate can be better. For example, because mechanical material parameters such as a modulus of a material in a thickness direction of the first cover plate are more symmetric, the first cover plate is not prone to warping. In addition, a unit weight of the first material layer may be less than a unit weight of the first sealing layer, and may be less than a unit weight of the second sealing layer. Compared with a first cover plate of a same thickness but without the first material layer, a total weight of the first cover plate can be further reduced, and a lightweight design is achieved.

In some embodiments, yield strain of the first material layer is greater than yield strain of the first sealing layer and greater than yield strain of the second sealing layer; and positions that are in the first sealing layer and the second sealing layer and that correspond to the buffer grooves include plastic deformation. The plastically deformed first sealing layer and second sealing layer can constrain the shape of the first material layer. In this case, the buffer grooves can be prepared through compression molding. This configuration further helps simplify a process and reduce production costs.

In some embodiments, top openings of at least some buffer grooves face one side that is of the first cover plate and that is away from the second cover plate. This configuration helps improve buffering and supporting effect of the first cover plate.

In some embodiments, a shape of any buffer groove includes any one of a circle, a polygon, a bar, and a wave strip. With this configuration, the buffer grooves can effectively provide a relatively good buffering protection function.

In some embodiments, the first cover plate further includes a first filler located in at least one of the buffer grooves, where a material of the first filler includes an organic polymer material. This configuration helps further improve a buffering protection capability of the first cover plate.

In some embodiments, the first cover plate further includes a second filler located in at least one of the buffer grooves, where a material of the second filler includes a phase-change energy storage material. This configuration helps further improve a thermal conduction capability of the first cover plate.

In some embodiments, a percentage of a thickness of the first material layer to a total thickness of the first cover plate is greater than or equal to 20%. With this configuration, the first cover plate achieves relatively good lightweight benefits. In addition, when a plurality of protruding structures are formed on the first cover plate through compression molding, problems of wrinkling or even fracturing are not likely to occur.

In some embodiments, the thickness of the first material layer is greater than or equal to 5 µm. With this configuration, the first cover plate achieves relatively good lightweight benefits. In addition, when a plurality of protruding structures are formed on the first cover plate through compression molding, problems of wrinkling or even fracturing are not likely to occur.

In some embodiments, a thickness of the first sealing layer is equal to or basically equal to a thickness of the second sealing layer. The term "basically equal" means that there may be a relatively small deviation between the two. For example, the relatively small deviation may mean that a thickness difference between the two is less than 5% of the thickness of the smaller one, or may mean that a thickness difference between the two is less than 10% of the thickness of the smaller one. The configuration in this example also helps make mechanical parameters of the first cover plate symmetric in the thickness direction, so that the first cover plate is not prone to warping.

In some embodiments, the first sealing layer and the second sealing layer are made of a same material. This configuration helps make the mechanical parameters of the first cover plate symmetric in the thickness direction, so that the first cover plate is not prone to warping.

In some embodiments, a material of the first material layer includes an organic polymer material. For example, the organic polymer material is polyimide (polyimide, PI), polypropylene (polypropylene, PP), polytetrafluoroethylene (polytetrafluoroethylene, PTFE), polyethylene terephthalate (polyethylene terephthalate, PET), polyethylene naphthalate (polyethylene naphthalate, PEN), polydimethylsiloxane (polydimethylsiloxane, PDMS), polyethylene (polyethylene, PE), polypropylene carbonate (polypropylene carbonate, PPC), polyviny chloride (polyviny chloride, PVC), polyvinylidene chloride (polyvinylidene chloride, PVdC), polystyrene (polystyrene, PS), polyamide (polyamide, PA), or the like. In this example, the first material layer may have relatively good plasticity and a higher elongation rate, so that the formed first cover plate is easy to undergo a shaping process such as stamping or hot pressing and is not prone to cracking.

In some embodiments, a material of at least one of the first sealing layer and the second sealing layer includes at least one of metal and ceramic. The metal includes copper, for example, may be pure copper or a copper alloy. In this example, the first sealing layer and/or the second sealing layer have/has relatively high structural strength, and the first sealing layer and/or the second sealing layer have/has relatively good sealing performance and toughness. This helps improve structural strength of the first cover plate and prolong the service life of the first cover plate.

In some embodiments, the second cover plate includes a third sealing layer and a second material layer; the second material layer is located on one side that is of the third sealing layer and that is away from the first cover plate; and yield strain of the second material layer is greater than yield strain of the third sealing layer.

In the embodiments, the second cover plate is set to further include the second material layer, and the yield strain of the second material layer is set to be greater than the yield strain of the third sealing layer, thereby improving structural strength of the second cover plate. For example, when structures such as micro-pillars and/or support pillars are etched on a surface of one side that is of the third sealing layer and that is away from the second material layer, a substrate of the third sealing layer may be etched to a thickness of 0.03 mm or less without wrinkles or cracks. In addition, a unit weight of the second material layer may be less than a unit weight of the third sealing layer. Compared with a second cover plate of a same thickness but without the second material layer, a total weight of the second cover plate can be further reduced, and a lightweight design can be achieved.

In some embodiments, a percentage of a thickness of the second material layer to a total thickness of the second cover plate is greater than or equal to 50%. With this configuration, the second cover plate achieves relatively good lightweight benefits. In addition, when structures such as micro-pillars and/or support pillars are etched on the second cover plate, and the second cover plate is bent for a plurality of times, problems of wrinkling or even fracturing are not likely to occur.

In some embodiments, a material of the second material layer includes an organic polymer material, for example, polyimide (polyimide, PI), polypropylene (polypropylene, PP), polytetrafluoroethylene (polytetrafluoroethylene, PTFE), polyethylene terephthalate (polyethylene terephthalate, PET), polyethylene naphthalate (polyethylene naphthalate, PEN), polydimethylsiloxane (polydimethylsiloxane, PDMS), polyethylene (polyethylene, PE), polypropylene carbonate (polypropylene carbonate, PPC), polyviny chloride (polyviny chloride, PVC), polyvinylidene chloride (polyvinylidene chloride, PVdC), polystyrene (polystyrene, PS), polyamide (polyamide, PA), or the like. In this example, the second material layer may have relatively good toughness, so that problems of wrinkling or even fracturing are not likely to occur on the formed second cover plate.

In some embodiments, a material of the third sealing layer includes at least one of metal and ceramic. The metal includes copper, for example, may be pure copper or a copper alloy. In this example, the third sealing layer has relatively high structural strength, and has relatively good sealing performance and toughness. This helps improve the structural strength of the second cover plate and prolong service life of the second cover plate.

In some embodiments, the second sealing layer is closer to the third sealing layer than the first sealing layer; and the material of the third sealing layer is the same as the material of the second sealing layer. This configuration facilitates welding and sealing of the third sealing layer and the second sealing layer, that is, facilitates welding and fastening of the first cover plate and the second cover plate.

In some embodiments, the second cover plate has a compression-molded placement groove on one side close to the first cover plate, and the liquid-absorbing structure is placed in the placement groove. In some examples, the second cover plate has the second material layer with better toughness, and an area of the placement groove formed through compression molding on the side that is of the second cover plate and that is close to the first cover plate is relatively large. Therefore, the structural strength of the second cover plate is still relatively high, and problems of wrinkling or even fracturing are not likely to occur.

In some embodiments, the third sealing layer has a groove on one side close to the first cover plate, the groove includes a first groove part and a second groove part, and the first groove part is closer to a bottom wall of the groove than the second groove part. The second cover plate further includes a plurality of pillar structures located in the first groove part, and the plurality of pillar structures are connected to the bottom wall. The liquid-absorbing structure includes a liquid-absorbing core, and the liquid-absorbing core is placed in the second groove part. The plurality of pillar structures support the liquid-absorbing core. In this solution, because the second cover plate has the second material layer with better toughness, the groove located at the third sealing layer may be formed through compression molding or etching. Regardless of the formation manner, the structural strength of the formed second cover plate is still relatively high. In addition, when the groove is formed through etching, the plurality of pillar structures in the groove may also be directly formed through etching. When the groove is formed through compression molding, the plurality of pillar structures in the groove may be formed through glue dispensing. This configuration helps ensure that the second cover plate has sufficient structural strength.

In some embodiments, the second cover plate includes at least two stacked metal layers. This configuration helps improve the structural strength of the second cover plate, thereby enhancing reliability of the entire heat dissipation structure.

In some embodiments, the at least two metal layers include any one of copper-steel, copper-titanium, copper-steel-copper, copper-titanium-copper, copper-aluminum-copper, copper-magnesium-copper, and copper-(magnesium-aluminum alloy)-copper. The selected composite material has relatively high strength. This can greatly improve overall mechanical structural performance of the heat dissipation structure, prevent deformation of the heat dissipation structure under compression, increase a manufacturing yield rate of the heat dissipation structure, and enhance overall reliability of the electronic device.

According to another aspect, another heat dissipation structure is provided and includes a fourth sealing layer, a third material layer, and a fifth sealing layer, where in a first direction, the third material layer is located between the fourth sealing layer and the fifth sealing layer; a material of the third material layer includes at least one of a graphite material and a graphene material; the heat dissipation structure has a plurality of buffer grooves spaced apart; and positions that are in the third material layer and that correspond to the buffer grooves include elastic deformation and/or plastic deformation.

In the another heat dissipation structure provided in embodiments of this application, because the material of the third material layer includes at least one of the graphite material and the graphene material, and the positions that are in the third material layer and that correspond to the buffer grooves include elastic deformation and/or plastic deformation, the heat dissipation structure achieves good heat dissipation effect and thermal uniformity, and in particular, a heat accumulation phenomenon is not likely to occur at the positions corresponding to the buffer grooves in the heat dissipation structure. In addition, because the fourth sealing layer and the fifth sealing layer are respectively provided on two opposite sides of the third material layer, on one hand, the third material layer can be sealed and protected well. Therefore, the third material layer is not likely to collapse. This can not only provide excellent buffering and supporting for a screen, and prevent screen failure problems such as shadows, dark spots, imprints, bright spots, green lines, or shattering, but also prevent thermal uniformity and heat dissipation capabilities of the heat dissipation structure from weakening due to the collapse of the third material layer, thereby prolonging service life of the heat dissipation structure and enhancing reliability of a first cover plate. On the other hand, because a relatively symmetric structure can be formed, flatness of the first cover plate can be better. For example, because mechanical material parameters such as a modulus of a material in a thickness direction of the first cover plate are more symmetric, the heat dissipation structure is not prone to warping. In addition, the third material layer is lighter in weight, and this helps reduce a total weight of the heat dissipation structure and achieve a lightweight design.

In some embodiments, thermal conductivity of the third material layer is greater than or equal to 400 W/(m·k). This configuration enables the heat dissipation structure to have relatively high thermal conduction efficiency.

In some embodiments, a material of at least one of the fourth sealing layer and the fifth sealing layer includes copper. With this configuration, the third material layer can be better sealed and protected, and heat dissipation efficiency is relatively high.

According to still another aspect, an electronic device is provided and includes a screen, a heat emitting component, and the heat dissipation structure according to any one of the foregoing embodiments. The heat dissipation structure is located between the screen and the heat emitting component.

Because the electronic device provided in embodiments of this application has the heat dissipation structure according to any one of the foregoing embodiments, the electronic device has good heat dissipation effect, a problem of severe localized heating is not likely to occur, the screen can be protected, and a lightweight design can be achieved.

In some embodiments, the electronic device further includes an adhesive layer located between the heat dissipation structure and the screen. Because the adhesive layer is disposed, the heat dissipation structure can be bonded and fastened to the screen. In addition, when the heat dissipation structure is bonded and fastened to the screen, because the heat dissipation structure has the buffer grooves, the buffer grooves can be further used to prevent a problem that the adhesive layer between the screen and the heat dissipation structure detaches and fails due to shear stress.

### BRIEF DESCRIPTION OF DRAWINGS

FIG. 1 is a diagram of a structure of an electronic device according to an embodiment of this application;
FIG. 2 is a diagram of a structure of a heat dissipation structure according to an embodiment of this application;
FIG. 3 is a schematic sectional view of the heat dissipation structure in FIG. 2 in an A-A direction;
FIG. 4 is a diagram of an operating principle of a heat dissipation structure and a gas-liquid phase working fluid flow according to an embodiment of this application;
FIG. 5 is a schematic sectional view of an electronic device according to an embodiment of this application;
FIG. 6 is a schematic sectional view of an electronic device when a screen is deformed according to an embodiment of this application;
FIG. 7 is a diagram of a structure of a first cover plate when no buffer groove is formed according to an embodiment of this application;
FIG. 8 is a stress-strain curve diagram of a first sealing layer (or a second sealing layer) and a first material layer according to an embodiment of this application;
FIG. 9 is a diagram of a structure of a jig and a first cover plate on which buffer grooves are formed through compression molding according to an embodiment of this application;
FIG. 10 is a diagram of a structure of a first cover plate according to an embodiment of this application;
FIG. 11 is a schematic sectional view of the first cover plate in FIG. 10 in a B-B direction;
FIG. 12 is a diagram of a structure of another first cover plate according to an embodiment of this application;
FIG. 13 is a diagram of a structure of still another first cover plate according to an embodiment of this application;
FIG. 14 is a diagram of a structure of still another first cover plate according to an embodiment of this application;
FIG. 15 is a diagram of a structure of a first cover plate cooperating with a screen according to an embodiment of this application;
FIG. 16 is a diagram of a structure of a heat dissipation structure according to an embodiment of this application;
FIG. 17 is a diagram of a structure of another heat dissipation structure according to an embodiment of this application;
FIG. 18 is a diagram of a structure of still another heat dissipation structure according to an embodiment of this application;
FIG. 19 is a diagram of a structure of still another heat dissipation structure according to an embodiment of this application;
FIG. 20 is a diagram of a structure of still another heat dissipation structure according to an embodiment of this application;
FIG. 21 is a diagram of a structure of a heat dissipation structure cooperating with a screen and a heat emitting component according to an embodiment of this application;
FIG. 22 is a diagram of a combination of a first cover plate and a second liquid-absorbing core according to an embodiment of this application;
FIG. 23 is a diagram of a structure of still another heat dissipation structure according to an embodiment of this application; and
FIG. 24 is a diagram of a structure of a heat dissipation structure cooperating with a screen according to an embodiment of this application.

### DESCRIPTION OF EMBODIMENTS

The following describes the technical solutions in the embodiments of this application with reference to the accompanying drawings in the embodiments of this application. Apparently, the described embodiments are only some rather than all of the embodiments of this application.

Hereinafter, the terms "first" and "second" are merely for convenience of description, and shall not be understood as an indication or implication of relative importance or an implicit indication of a quantity of indicated technical features. Therefore, a feature defined by "first", "second", or the like may explicitly or implicitly include one or more features. In the description of this application, "a plurality of" means at least two unless otherwise stated.

In embodiments of this application, unless otherwise specified and defined, the term "electrical connection" may be direct electrical connection, or may be indirect electrical connection through an intermediate medium.

In embodiments of this application, the term "example", "for example", or the like is used to represent an example, an illustration, or a description. Any embodiment or design scheme described as "example" or "for example" in embodiments of this application should not be construed as being more preferred or advantageous than another embodiment or design scheme. Exactly, use of the term such as "example" or "for example" is intended to present a relative concept in a specific manner.

In embodiments of this application, the term "and/or" describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between associated objects.

In embodiments of this application, for example, on, under, left, right, front, and rear are relative direction indications used to explain structures and movement of different parts in this application. These indications are appropriate when the parts are in positions shown in figures. However, if descriptions of the positions of the parts change, these direction indications correspondingly change.

An embodiment of this application provides an electronic device. The electronic device may be a device such as a mobile phone, a tablet computer (tablet personal computer), a laptop computer (laptop computer), a personal digital assistant (personal digital assistant, PDA), a camera, a personal computer, a notebook computer, an in-vehicle device, a wearable device, a watch, augmented reality (augmented reality, AR) glasses, an AR helmet, virtual reality (virtual reality, VR) glasses, or a VR helmet. For example, the electronic device may be a portable electronic device. For example, the electronic device may be any electronic device that has a heat dissipation requirement.

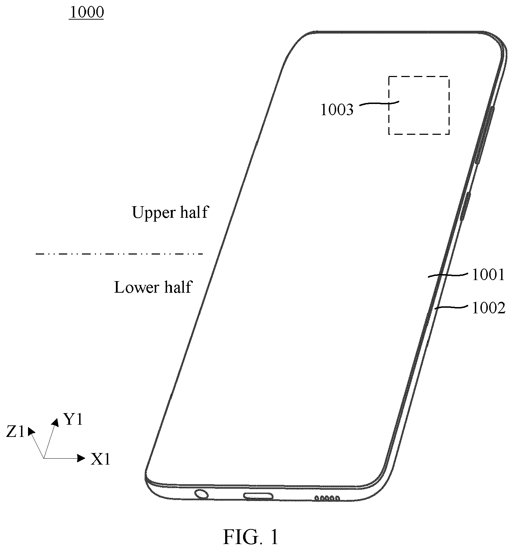

Refer to FIG. 1. FIG. 1 is a diagram of a structure of an electronic device 1000 according to an embodiment of this application. For ease of description, a width direction of the electronic device 1000 is defined as an X1 axis, a length direction of the electronic device 1000 is defined as a Y1 axis, and a thickness direction of the electronic device 1000 is defined as a Z1 axis. It may be understood that a coordinate system of the electronic device 1000 may be flexibly set based on a specific actual requirement.

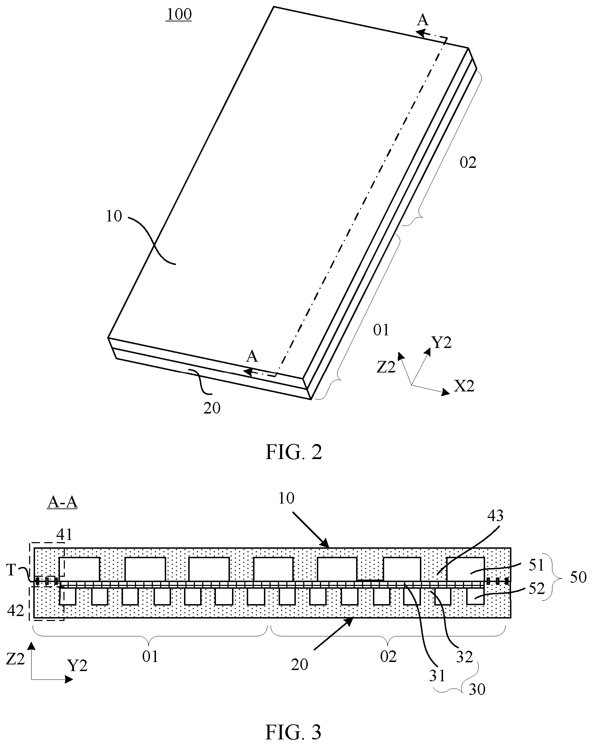

In the embodiment in FIG. 1, the electronic device 1000 is a mobile phone. For example, the electronic device 1000 may include a screen 1001, a rear housing 1002, and a heat emitting component 1003. It may be understood that FIG. 1 and FIG. 2 only schematically show some components included in the electronic device 1000. Actual shapes, actual sizes, actual positions, and actual structures of these components are not limited by FIG. 1 and FIG. 2. For example, in some other examples, the electronic device 1000 may alternatively not include the screen 1001.

The screen 1001 is configured to display an image, a video, and the like. The screen 1001 may be a flexible display screen or a rigid display screen. For example, the screen 1001 may be any one of an organic light-emitting diode (organic light-emitting diode, OLED) display screen, an active matrix organic light-emitting diode or active matrix organic light-emitting diode (active-matrix organic light-emitting diode, AMOLED) display screen, a mini light-emitting diode (mini organic light-emitting diode) display screen, a micro light-emitting diode (micro organic light-emitting diode) display screen, a micro organic light-emitting diode (micro organic light-emitting diode) display screen, a quantum dot light-emitting diode (quantum dot light emitting diode, QLED) display screen, and a liquid crystal display screen (liquid crystal display, LCD).

The rear housing 1002 is configured to protect an internal electronic component (for example, the heat emitting component 1003) of the electronic device 1000. The rear housing 1002 may include a rear cover and a middle frame, and the middle frame is fastened on the rear cover. For example, the middle frame may be fastened to the rear cover by using adhesive. Alternatively, the middle frame may be structurally integrated with the rear cover, that is, the middle frame and the rear cover constitute an integrated structure. The screen 1001 may be connected to the middle frame. Components such as a circuit board and a battery may be provided in space between the screen, the middle frame, and the rear cover. The circuit board may include a flexible circuit board and a rigid circuit board. A power component such as a chip may be disposed on the circuit board.

For example, the heat emitting component 1003 may be a chip on the circuit board, and the chip may be, for example, a processing chip or a storage chip. Certainly, in some other embodiments, the heat emitting component 1003 may also be another power component in the electronic device 1000. For example, any component that generates heat when the electronic device 1000 runs may be the heat emitting component 1003. In addition, there may be one, two, or more heat emitting components 1003 in the electronic device 1000. When there are two or more heat emitting components 1003, at least some of the heat emitting components 1003 may be of a same type. For example, there may be two processing chips. For another example, there may be two storage chips.

Through research, the inventors of this application find that, because the electronic device 1000 has the heat emitting component 1003, the electronic device 1000 has a problem of severe localized heating. For example, in the embodiment in FIG. 1, because the heat emitting component 1003 is located in an upper half of the electronic device 1000, there is a problem that it is difficult to promptly dissipate heat of the heat emitting component 1003 from the upper half to a lower half. Therefore, performance of each component in the upper half of the electronic device 1000 is degraded, service life is shortened, and a part of the screen directly facing the heat emitting component is easily burnt, affecting display effect.

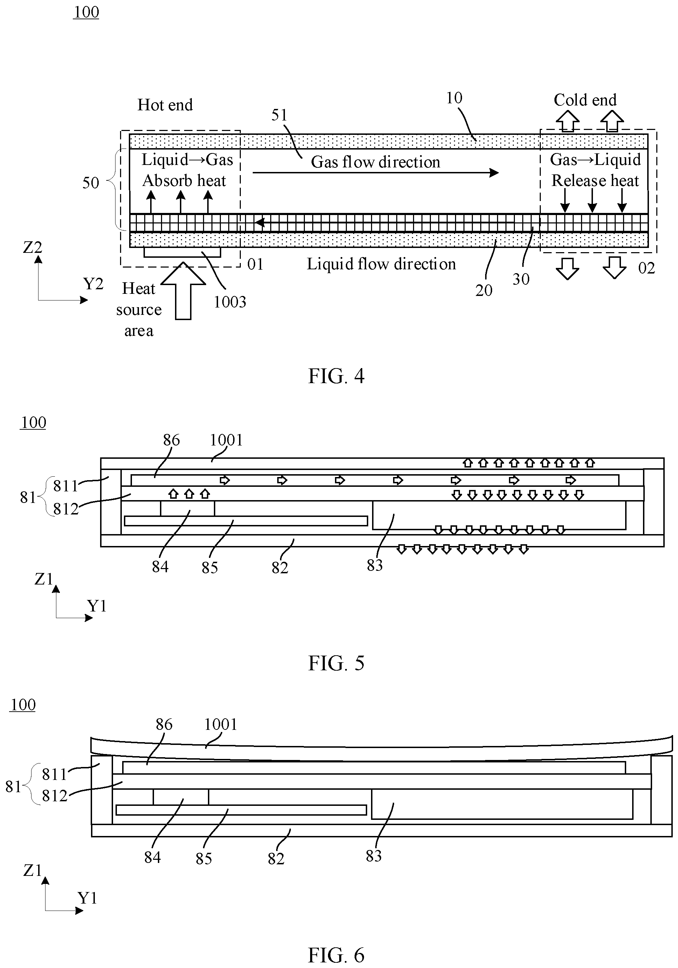

Based on this, some embodiments of this application provide a heat dissipation structure 100. The heat dissipation structure 100 may be connected to a middle frame. Refer to FIG. 2 to FIG. 4. FIG. 2 is a diagram of a structure of a heat dissipation structure 100 according to an embodiment of this application. FIG. 3 is a schematic sectional view of the heat dissipation structure 100 in FIG. 2 in an A-A direction. FIG. 4 is a diagram of an operating principle of the heat dissipation structure 100 and a gas-liquid phase working fluid flow according to an embodiment of this application. The heat dissipation structure 100 provided in this embodiment of this application includes a first cover plate 10, a second cover 20, and a liquid-absorbing structure 30.

The first cover plate 10 and the second cover plate 20 are connected to each other to form a receptacle 50. For example, an edge 41 of the first cover plate 10 and an edge 42 of the second cover plate 20 may be welded and fastened (for example, a welding point T in FIG. 3 may be included). A welding method may be a low-temperature welding process such as brazing, cold welding, pressure welding, diffusion welding, ultrasonic welding, or electromagnetic pulse welding. A welding temperature is lower than 320°C. In addition, during welding, no solder may be used, or a solder layer may be added.

For ease of description, a width direction of the heat dissipation structure 100 is defined as an X2 axis, and the X2 axis may be parallel to the foregoing X1 axis; a length direction of the heat dissipation structure 100 is defined as a Y2 axis, and the Y2 axis may be parallel to the foregoing Y1 axis; and a thickness direction of the heat dissipation structure 100 is defined as a Z2 axis, and the Z2 axis may be parallel to the foregoing Z1 axis. It may be understood that a coordinate system of the heat dissipation structure 100 may be flexibly set based on a specific actual requirement.

The heat dissipation structure 100 has a first area 01 and a second area 02. The first area 01 and the second area 02 may be arranged along a Y2 axis direction. It may be understood that the first area 01 and the second area 02 may be adjacent (as shown in FIG. 2 and FIG. 3), or may not be adjacent (as shown in FIG. 4, located at two ends of the heat dissipation structure along the Y2 axis direction).

The liquid-absorbing structure 30 is located in the receptacle 50. The liquid-absorbing structure may extend from the first area 01 to the second area 02. For example, there may be one or more liquid-absorbing structures 30. When there are a plurality of liquid-absorbing structures, the plurality of liquid-absorbing structures may be spaced apart in parallel. In this case, each liquid-absorbing structure 30 may extend from the first area 01 to the second area 02. In addition, a vapor channel 51 is further provided in the receptacle 50, and the vapor channel 51 may extend from the second area 02 to the first area 01, to form a circulation loop for a working fluid (for example, pure water, propanol, or alcohol).

For example, the liquid-absorbing structure 30 may include a liquid-absorbing core 31. The liquid-absorbing core 31 may be a mesh structure with dense through holes, such as a woven mesh or an etched perforated mesh, for example, a copper mesh, a stainless steel mesh, or a woven mesh made of an organic material. The copper mesh may be formed by sintering copper powder, or the copper mesh may be woven from copper wires. The liquid-absorbing core 31 may be a capillary structure.

For another example, the liquid-absorbing structure 30 may include a plurality of micro-pillars 32 disposed on the first cover plate 10 and/or the second cover plate 20. For example, in the embodiment in FIG. 3, a plurality of micro-pillars 32 are disposed in an inner wall surface of the second cover plate 20. There are fine grooves 52 between the plurality of micro-pillars 32 (for example, a groove depth may be less than or equal to 0.1 mm, and a groove width may be less than or equal to 1 mm), forming a capillary structure.

For another example, as shown in FIG. 3, the liquid-absorbing structure 30 may include both a liquid-absorbing core 31 and a plurality of micro-pillars 32 located on the first cover plate 10 and/or the second cover plate 20, thereby forming a two-layer or three-layer composite capillary structure. FIG. 3 is merely an example of a two-layer composite capillary structure that includes a liquid-absorbing core and a plurality of micro-pillars 32 located on the second cover plate 20.

The meaning of the capillary structure is as follows: Because a liquid surface of liquid has surface tension, when the liquid is infiltrated into a capillary hole, the liquid surface of the liquid is concave, so that the liquid surface exerts pull force on the liquid below, causing the liquid to move upward along a wall of the capillary hole. This causes a capillary phenomenon. The capillary structure may include a plurality of capillary holes or a structure such as a fine groove similar to a capillary hole. Therefore, after a liquid working fluid enters the capillary hole or the fine groove in the capillary structure, the liquid working fluid flows to the other end of the capillary hole under a capillary action, thereby completing transfer and return of the working fluid.

For example, the heat dissipation structure 100 may be a vapor chamber (Vapor chamber, VC). The vapor chamber, also known as a thin vapor chamber, is a vacuum chamber with a microstructure (capillary structure) on its inner wall and filled with a working fluid. An operating principle of the vapor chamber is largely the same as that of a heat pipe, and specifically includes four main steps: conduction, evaporation, convection, and condensation. A material of the vapor chamber may be copper, and the working fluid in the vapor chamber may be pure water.

In some embodiments, a plurality of support pillars 43 may be disposed on the first cover plate 10 and/or the second cover plate 20. For example, in the embodiment in FIG. 4, a plurality of support pillars 43 are disposed in an inner wall surface of the first cover plate 10. The support pillars 43 are configured to prevent the heat dissipation structure 100 from collapsing. The vapor channel 51 may be formed between the plurality of support pillars. A depth of the vapor channel 51 may be greater than 0.1 mm, and a width of the vapor channel 51 may be greater than 1 mm.

For example, a center distance between two adjacent support pillars 43 may be greater than 2 mm. In this case, the heat dissipation structure 100 is less likely to collapse.

For example, in the first cover plate 10 and the second cover plate 20, when the plurality of support pillars 43 are disposed on the inner wall surface of one cover plate, and the plurality of micro-pillars 32 are disposed on the inner wall surface of the other cover plate, the plurality of support pillars 43 may be designed to be directly opposite to the plurality of micro-pillars 32 (for example, one support pillar 43 is directly opposite to one micro-pillar 32, or one support pillar 43 is directly opposite to two or more micro-pillars 32), so that the heat dissipation structure 100 can have higher structural strength. Therefore, the heat dissipation structure 100 is not likely to collapse and block the vapor channel 51, the heat dissipation structure 100 is not likely to fail, and reliability is higher.

On this basis, for example, the liquid-absorbing core 31 may be disposed between the plurality of support pillars 43 and the plurality of micro-pillars 32. In this case, the plurality of support pillars 43 may press against a first surface of the liquid-absorbing core 31, the plurality of micro-pillars 32 may press against a second surface of the liquid-absorbing core 31, and the second surface is opposite to the first surface.

It may be understood that the foregoing is merely an example for describing positions at which the support pillars 43 and the micro-pillars 32 are disposed. In another embodiment of this application, the support pillars 43 may be disposed on the second cover plate 20, and the micro-pillars 32 may be disposed on the first cover plate 10. Alternatively, the support pillars 43 may be disposed on both the first cover plate 10 and the second cover plate 20, or the micro-pillars 32 may be disposed on both the first cover plate 10 and the second cover plate 20.

When the heat dissipation structure 100 provided in this embodiment of this application is applied to the electronic device 1000, the heat dissipation structure 100 may be located between the screen 1001 and the heat emitting component 1003. In this case, the first cover plate 10 may be close to the screen 1001, and the second cover plate 20 may be close to the heat emitting component 1003; or the second cover plate 20 may be close to the screen 1001, and the first cover plate 10 may be close to the heat emitting component 1003. This is not limited in this application.

For example, as shown in FIG. 4, a part that is of the second cover plate 20 and that is located in the first area 01 may be used to contact the heat emitting component 1003 in a heat source area. When heat generated by the heat emitting component 1003 is conducted into the heat dissipation structure 200 through the part that is of the second cover plate 20 and that is in the first area 01, a liquid working fluid that is in the heat dissipation structure 100 and that is close to the heat emitting component 1003 absorbs heat and then rapidly vaporizes, taking away a large amount of heat. Then, by using latent heat of vapor, when the vapor in the heat dissipation structure 100 diffuses from a high-pressure area (for example, the first area 01, which is a high-temperature area in this case) to a low-pressure area (for example, the second area 02, which is a low-temperature area in this case) through the vapor channel 51, and the vapor contacts an inner wall with a relatively low temperature, the vapor quickly condenses into a liquid state and releases thermal energy. The working fluid condensed into the liquid state returns to the first area 01 under the capillary action of the liquid-absorbing structure (that is, the capillary structure). In this way, a heat conduction cycle is completed, and a bidirectional circulation system in which both gas and liquid phases of the working fluid coexist is formed.

It can be learned that the heat dissipation structure 100 provided in this embodiment of this application can promptly dissipate heat of the heat emitting component 1003. For example, heat may be promptly dissipated from the upper half (in contact with a part that is of the heat dissipation structure 100 and that is located in the first area 01) of the electronic device 1000 in the embodiment in FIG. 1 to the lower half (in contact with a part that is of the heat dissipation structure 100 and that is located in the second area 02). Therefore, a problem of severe localized heating of the electronic device 1000 is not likely to occur. This can alleviate problems caused by overheating in a local area, such as performance degradation and shortened service life of components in the area, as well as screen burning and impact on display effect.

In addition, in some other implementations, the heat dissipation structure 100 may be further replaced with a graphite sheet and/or a graphene film. It may be understood that, when both the graphite sheet and the graphene film are included, the graphite sheet and the graphene film may be stacked along a Z1 axis direction. The graphite sheet and the graphene film have excellent thermal conduction effect. In this case, the heat of the heat emitting component 1003 can be effectively dissipated by using the graphite sheet and/or the graphene film.

Refer to FIG. 5. FIG. 5 is a schematic sectional view of an electronic device 1000 according to an embodiment of this application. The electronic device 1000 includes a middle frame 81, a rear cover 82, a screen 1001, a battery 83, a chip 84, a mainboard 85, and a heat dissipation member 86. The middle frame 81 includes a side frame 811 and a middle plate 812. One end of the side frame 811 is connected to the screen 1001 along a Z1 axis direction, and the other end of the side frame 811 is connected to the rear cover 82. The middle plate 812 is connected and fastened on an inner side of the side frame. The chip 84, the mainboard 85, and the battery 83 are located between the middle plate 812 and the rear cover 82. The chip 84 is located on the mainboard 85, and the chip 84 is in contact with the middle plate 812. The battery 83 and the mainboard 85 are arranged along a specified direction (for example, a Y1 axis direction). The heat dissipation member 86 is located between the middle plate 812 and the screen 1001. The heat dissipation member 86 may be connected to the middle frame (for example, in a form of bonding, edge welding, or screw fastening). For example, the heat dissipation member 86 may be at least one of the foregoing heat dissipation structure 100, graphite sheet, and graphene film. Heat of the chip 84 may be dissipated in an arrow direction.

Refer to FIG. 6. FIG. 6 is a schematic sectional view of an electronic device 1000 when a screen 1001 is deformed according to an embodiment of this application. Through further research with reference to FIG. 5 and FIG. 6, the inventors of this application find that, in absence of the heat dissipation member 86, the screen is prone to deformation when subjected to external force (for example, compressive force) because there is a relatively large air gap between the screen and the middle plate. Consequently, the screen lacks support and is prone to shattering. In some embodiments of this application, the heat dissipation member 86 is disposed, so that buffering and supporting effect can be achieved, and the foregoing problem can be alleviated to some extent. However, when a graphite sheet and a graphene film are used as the heat dissipation member 86, because the graphite sheet and the graphene film are very soft, when the screen is deformed under compression, buffering and supporting capabilities are very weak, and there is still a high risk of screen shattering. However, when the heat dissipation structure 100 is used as the heat dissipation member 86, because a housing (the first cover plate and the second cover plate) of the heat dissipation structure is made of a metal material (such as copper, a copper alloy, or stainless steel) with a high elastic modulus, high hardness, and a low elongation rate, when the screen is in contact with the housing of the heat dissipation structure due to external impact, the housing generates great rebound force on the screen, and as a result, the screen is prone to failure problems such as shadows, dark spots, imprints, bright spots, green lines, or shattering.

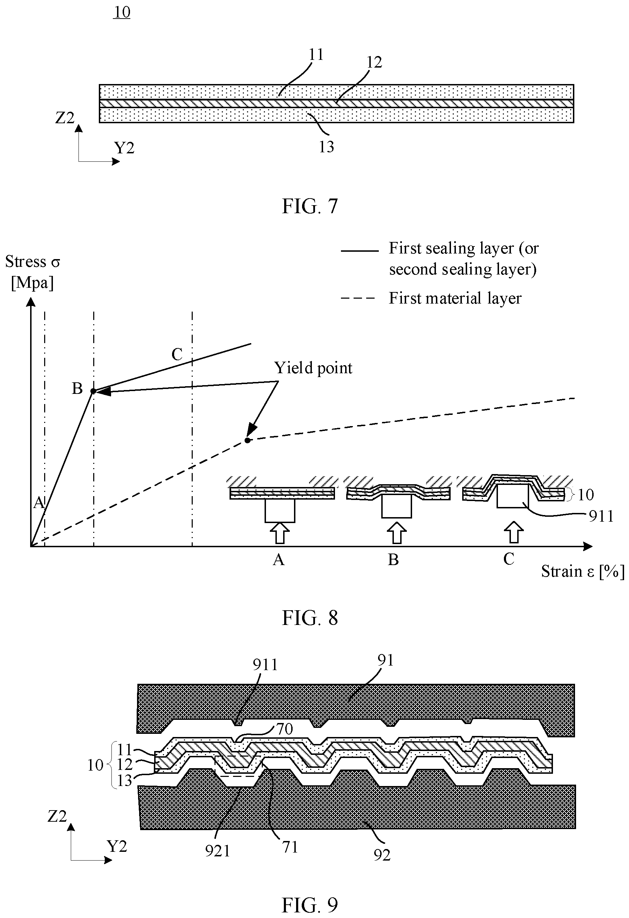

Based on this, refer to FIG. 7, FIG. 8, and FIG. 9. FIG. 7 is a diagram of a structure of a first cover plate 10 when no buffer groove 70 is formed according to an embodiment of this application. FIG. 8 is a stress-strain curve diagram of a first sealing layer 11 (or a second sealing layer 13) and a first material layer 12 according to an embodiment of this application. FIG. 9 is a diagram of a structure of a jig and a first cover plate 10 on which buffer grooves 70 are formed through compression molding according to an embodiment of this application. In some embodiments of this application, the first cover plate 10 includes the first sealing layer 11, the first material layer 12, and the second sealing layer 13, and the first material layer 12 is located between the first sealing layer 11 and the second sealing layer 13. The first cover plate 10 has a plurality of buffer grooves 70 on a surface of one side away from the second cover plate 20, and the plurality of buffer grooves 70 are spaced apart. Positions that are in the first material layer 12 and that correspond to the buffer grooves 70 include elastic deformation. It may be understood that, herein, the positions that are in the first material layer 12 and that correspond to the buffer grooves 70 include elastic deformation, but this does not completely exclude a case of local plastic deformation also included at the positions that are in the first material layer 12 and that correspond to the buffer grooves 70. The elastic deformation herein may be determined based on whether the first material layer 12 rebounds after the first sealing layer 11 and the second sealing layer 13 are removed. The rebound herein does not require the first material layer 12 to completely rebound to the planar state.

In some examples, yield strain of the first material layer 12 is greater than yield strain of the first sealing layer 11 and greater than yield strain of the second sealing layer 13. Positions that are in the first sealing layer 11 and the second sealing layer 13 and that correspond to the buffer grooves include plastic deformation. The plastically deformed first sealing layer 11 and second sealing layer 13 can constrain the shape of the first material layer 12. The strain may include surface strain: ε = (Area variation/Initial total area) x 100%. The yield strain refers to strain corresponding to a yield point position, that is, a horizontal coordinate value corresponding to the yield point position shown in FIG. 8. The strain may also be understood as a boundary point between elastic deformation and plastic deformation. In this case, the buffer grooves 70 can be prepared through compression molding. For example, as shown in FIG. 9, the jig includes an upper stamping die 91 and a lower stamping die 92, the upper stamping die 91 includes bumps 911, and the lower stamping die 92 includes pits 921. When the upper stamping die 91 and the lower stamping die 92 are close to each other, the bumps 911 may cooperate with the pits 921 to form the buffer grooves 70 on the first cover plate 10 through compression molding. For example, it can be learned from FIG. 8 that, after the bumps 911 get in contact with the first cover plate 10, the first cover plate 10 may undergo three stages. At stage A, the first cover plate 10 is not obviously deformed; at stage B, the first sealing layer 11, the first material layer 12, and the second sealing layer 13 in the first cover plate 10 are all elastically deformed; at stage C, the first material layer 12 in the first cover plate 10 is still elastically deformed, and the first sealing layer 11 and the second sealing layer 13 are plastically deformed. Therefore, the first sealing layer 11 and second sealing layer 13 can be used to constrain a deformation shape of the first material layer 12.

It should be noted that FIG. 9 and some subsequent accompanying drawings are merely examples of forming the buffer grooves through compression molding. Certainly, in some other embodiments, another process may be used (for example, in two opposite surfaces of the elastically deformed first material layer 12, the first sealing layer 11 is electroplated on one surface, and the second sealing layer 13 is electroplated on the other surface, to restrict restoration of the first material layer 12 to an original state) and form the buffer grooves 70. Therefore, in some embodiments of this application, a manner of forming the buffer grooves 70 may not be limited, as long as the following is ensured: The positions that are in the first material layer 12 and that correspond to the buffer grooves 70 include elastic deformation, and the buffer grooves 70 can absorb stress when the first cover plate 10 is deformed. In addition, shapes and sizes of any two buffer grooves 70 may be the same, or may be different.

In the heat dissipation structure 100 provided in this embodiment of this application, because the first cover plate 10 has the plurality of buffer grooves 70, and the plurality of buffer grooves 70 are spaced apart, the first cover plate 10 has relatively good buffering and supporting functions. In addition, the first cover plate 10 includes the first sealing layer 11, the first material layer 12, and the second sealing layer 13; the first material layer 12 is sandwiched between the first sealing layer 11 and the second sealing layer 13; and the positions that are in the first material layer 12 and that correspond to the buffer grooves 70 include elastic deformation. Therefore, the buffer grooves 70 of the first cover plate 10 have better stress absorption and release capabilities, and compression deformation and restoration capabilities of the first cover plate 10 can be further improved. For example, when the heat dissipation structure 100 is applied to the foregoing electronic device 1000, for example, when the heat dissipation structure 100 is compressed by the foregoing screen 1001, because the first cover plate 10 has excellent buffering and supporting functions, and the buffer grooves 70 have better stress absorption and release capabilities, the first cover plate 10 has better flexibility. In addition, because the first material layer 12 constrained by the first sealing layer 11 and the second sealing layer 13 does not have excessive rebound force, failure problems such as shadows, dark spots, imprints, bright spots, green lines, or shattering caused by excessive rebound force of the first cover plate 10 are not likely to occur on the screen 1001.

In addition, because the first sealing layer 11 and the second sealing layer 13 are respectively provided on two opposite sides of the first material layer 12, on one hand, the first material layer 12 can be sealed and protected well, thereby prolonging service life of the first cover plate 10 and enhancing reliability of the first cover plate 10; on the other hand, because a relatively symmetric structure can be formed, flatness of the first cover plate 10 can be better. For example, because mechanical material parameters such as a modulus of a material in the thickness direction of the first cover plate 10 are more symmetric, the first cover plate 10 is not prone to warping. In addition, a unit weight of the first material layer 12 may be less than a unit weight of the first sealing layer 11, and may be less than a unit weight of the second sealing layer 13. Compared with a first cover plate 10 of a same thickness but without the first material layer 12, a total weight of the first cover plate 10 can be further reduced, and a lightweight design is achieved.

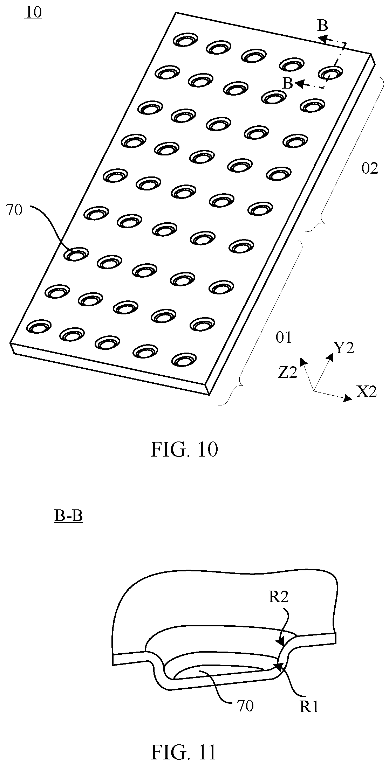

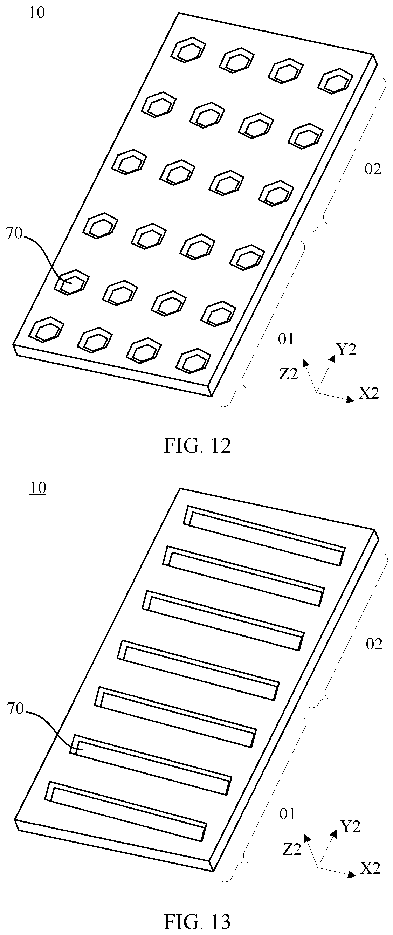

In some embodiments, a shape of any buffer groove 70 includes any one of a circle, a polygon, a bar, and a wave strip. Herein, the shape of the buffer groove 70 may be understood as an orthographic projection of the buffer groove 70 on an X2-Y2 plane. Refer to FIG. 10 to FIG. 13. FIG. 10 is a diagram of a structure of a first cover plate 10 according to an embodiment of this application. FIG. 11 is a schematic sectional view of the first cover plate 10 in FIG. 10 in a B-B direction. FIG. 12 is a diagram of a structure of another first cover plate according to an embodiment of this application. FIG. 13 is a diagram of a structure of still another first cover plate 10 according to an embodiment of this application. FIG. 10 and FIG. 11 show examples in which shapes of buffer grooves 70 are circles. FIG. 12 shows an example in which shapes of buffer grooves 70 are hexagons. FIG. 13 shows an example in which shapes of buffer grooves 70 are bars. A wave strip may form a wave shape along a Y2 axis direction and/or a Z2 axis direction based on a bar.

For example, referring to FIG. 11, a rounded corner R1 may be further arranged at the bottom of a buffer groove 70, and a rounded corner R2 may be arranged at the top of the buffer groove 70. With this configuration, when the first cover plate 10 is bent, the first cover plate 10 is not likely to break at a position at which the buffer groove 70 is arranged. Herein, only an example in which the shape of the buffer groove 70 in FIG. 11 is a circle is used for description. For the embodiments in FIG. 12 and FIG. 13, structures similar to the foregoing rounded corner R1 and rounded corner R2 may also be provided.

In addition, in all the embodiments in FIG. 10 to FIG. 13, it is assumed that all the buffer grooves 70 on the first cover plate 10 have a same shape and size. However, this is not limited in this application. For example, buffer grooves 70 of different shapes and sizes may also exist on the same first cover plate 10.

In some embodiments, top openings of at least some buffer grooves 70 (for example, one, two, or more buffer grooves 70) face one side that is of the first cover plate 10 and that is away from the second cover plate 20. For example, in the embodiments in FIG. 10, FIG. 12, and FIG. 13, the top openings of the buffer grooves 70 face a direction indicated by a Z2 axis. With this configuration, buffering functions of the buffer grooves 70 can be fully used. For example, in this case, the second cover plate 20 may be disposed to contact the screen 1001, and the first cover plate 10 is located on one side that is of the second cover plate 20 and that is away from the screen 1001. This helps alleviate a screen imprint problem caused by the buffer grooves 70.

In some other embodiments, top openings of at least some buffer grooves 70 (for example, one, two, or more buffer grooves 70) face one side that is of the first cover plate 10 and that is close to the second cover plate 20. For example, the top opening of the buffer groove 70 may face a direction indicated by a -Z2 axis. This configuration can prevent a screen imprint problem when the first cover plate 10 is in contact with the screen 1001.

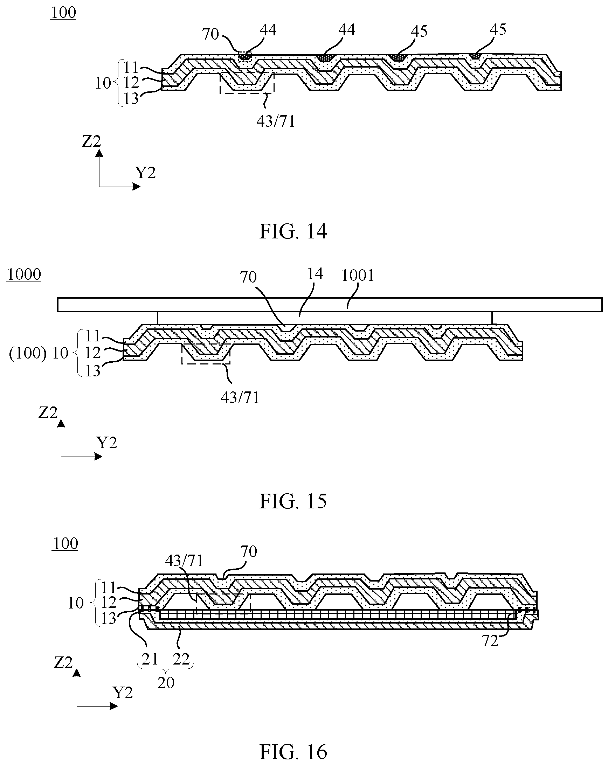

Refer to FIG. 14. FIG. 14 is a diagram of a structure of still another first cover plate 10 according to an embodiment of this application.

In some embodiments, the first cover plate 10 further includes a first filler 44 located in at least one of the buffer grooves 70. A material of the first filler 44 includes an organic polymer material. This configuration helps further improve a buffering protection capability of the first cover plate 10. The organic polymer material includes at least one of polyimide (polyimide, PI), polypropylene (polypropylene, PP), polytetrafluoroethylene (polytetrafluoroethylene, PTFE), polyethylene terephthalate (polyethylene terephthalate, PET), polyethylene naphthalate (polyethylene naphthalate, PEN), polydimethylsiloxane (polydimethylsiloxane, PDMS), polyethylene (polyethylene, PE), polypropylene carbonate (polypropylene carbonate, PPC), polyviny chloride (polyviny chloride, PVC), polyvinylidene chloride (polyvinylidene chloride, PVdC), polystyrene (polystyrene, PS), and polyamide (polyamide, PA).

In some embodiments, the first cover plate 10 further includes a second filler 45 located in at least one of the buffer grooves 70, where a material of the second filler 45 includes a phase-change energy storage material. This configuration helps further improve a thermal conduction capability of the first cover plate 10. The phase-change energy storage material is a material that changes to different states (for example, a liquid and a gas state, a liquid and a solid state, or a solid state and a gas state) at different temperatures. In this case, a sealing cover layer may be further disposed to confine the phase-change energy storage material within the buffer groove 70.

It may be understood that FIG. 14 shows an example in which a first filler 44 is disposed in some of the plurality of buffer grooves 70 of the first cover plate 10, and a second filler 45 is disposed in other buffer grooves 70. However, in other embodiments, the first filler 44 may be disposed in all the buffer grooves 70, or the second filler 45 may be disposed in all the buffer grooves 70; or both the first filler 44 and the second filler 45 may be filled in a same buffer groove 70.

In some embodiments, refer to FIG. 15. FIG. 15 is a diagram of a structure of a first cover plate 10 cooperating with a screen 1001 according to an embodiment of this application. The electronic device 1000 may further include an adhesive layer 14, and the adhesive layer 14 is located between the heat dissipation structure 100 and the screen 1001. For example, the adhesive layer 14 may be located on one side (as shown in FIG. 15) that is of the first cover plate 10 and that is away from the second cover plate 20, or located on one side (not shown in the figure) that is of the second cover plate 20 and that is away from the first cover plate 10. The adhesive layer 14 is disposed, so that the first cover plate 10 (or the second cover plate 20) can be bonded and fastened to the screen 1001. In addition, when the adhesive layer 14 is located on one side that is of the first cover plate 10 and that is away from the second cover plate 20, because the first cover plate 10 has the buffer grooves 70, the buffer grooves 70 can be further used to prevent a problem that the adhesive layer 14 between the screen 1001 and the first cover plate 10 detaches and fails due to shear stress. In addition, when the phase-change energy storage material is disposed in the buffer grooves 70, the adhesive layer 14 may also be equivalent to the foregoing sealing cover layer, to confine the phase-change energy storage material within the buffer grooves 70.

In some embodiments, with reference to FIG. 9, FIG. 14, and FIG. 15, a plurality of protruding structures 71 are further disposed on the first cover plate 10, and any protruding structure 71 protrudes in a direction close to the second cover plate 20. The protruding structures 71 herein may serve as the foregoing support pillars 43, or may serve as the foregoing micro-pillars 32, or may be structures for other purposes. Specific sizes and purposes of the protruding structures 71 are not limited in this application. For example, the protruding structures 71 may be formed through compression molding (for example, a shaping process such as stamping or hot pressing), and protrude in a direction (for example, a -Z2 axis direction) close to the second cover plate 20. For example, the protruding structures 71 may be compression-molded by using the jig in the embodiment in FIG. 9. In this case, the protruding structures 71 may be formed together with the buffer grooves 70. The process is simple, and costs are lower.

In addition, it should be noted that, when the second sealing layer 13 is closer to the second cover plate than the first sealing layer 11, if the support pillars 43 need to be etched on a surface of one side that is of the first cover plate 10 and that is close to the second cover plate 20, and a sufficient vapor channel height needs to be formed, the second sealing layer 13 needs to have a sufficient thickness, for example, greater than 0.15 mm, causing a significant increase in the weight of the first cover plate 10. However, for the first cover plate 10 provided in some embodiments of this application, the buffer grooves 70 and the protruding structures 71 (for example, the support pillars 43 or the micro-pillars 32) may be formed by using a shaping process such as stamping or hot pressing, so that the first cover plate 10 is more lightweight and that production costs are reduced.

For example, a material of the first sealing layer 11 may include metal or ceramic. The metal may be pure copper, a copper alloy, or the like. In this example, the first sealing layer 11 has relatively high structural strength, and the first sealing layer 11 has relatively good sealing performance and toughness. This helps improve structural strength of the first cover plate 10 and prolong the service life of the first cover plate 10.

For example, a material of the second sealing layer 13 may include metal or ceramic. The metal may be pure copper, a copper alloy, or the like. In this example, the second sealing layer 13 has relatively high structural strength, and the second sealing layer 13 has relatively good sealing performance and toughness. This helps improve the structural strength of the first cover plate 10 and prolong the service life of the first cover plate 10.

For example, the first sealing layer 11 and the second sealing layer 13 are made of a same material. This configuration helps make mechanical parameters of the first cover plate 10 symmetric in the thickness direction (Z2 axis), so that the first cover plate 10 is not prone to warping.

For example, a thickness of the first sealing layer 11 is equal to or basically equal to a thickness of the second sealing layer 13. The term "basically equal" means that there may be a relatively small deviation between the two. For example, the relatively small deviation may mean that a thickness difference between the two is less than 5% of the thickness of the smaller one, or may mean that a thickness difference between the two is less than 10% of the thickness of the smaller one.

The configuration in this example also helps make mechanical parameters of the first cover plate 10 symmetric in the thickness direction (Z2 axis), so that the first cover plate 10 is not prone to warping.

For example, thermal conductivity of the first material layer 12 is greater than or equal to 400 W/(m·k). For example, the thermal conductivity of the first material layer 12 may be 400 W/(m·k), 500 W/(m·k), 600 W/(m·k), or 800 W/(m·k). This configuration enables the first cover plate 10 to have relatively high thermal conduction efficiency.

In some embodiments, a material of the first material layer 12 may include an organic polymer material, and the organic polymer material includes polyimide (polyimide, PI), polypropylene (polypropylene, PP), polytetrafluoroethylene (polytetrafluoroethylene, PTFE), polyethylene terephthalate (polyethylene terephthalate, PET), polyethylene naphthalate (polyethylene naphthalate, PEN), polydimethylsiloxane (polydimethylsiloxane, PDMS), polyethylene (polyethylene, PE), polypropylene carbonate (polypropylene carbonate, PPC), polyviny chloride (polyviny chloride, PVC), polyvinylidene chloride (polyvinylidene chloride, PVdC), polystyrene (polystyrene, PS), polyamide (polyamide, PA), or the like.

In this example, the first material layer 12 may have relatively good plasticity and a higher elongation rate, so that the formed first cover plate 10 is easy to undergo a shaping process such as stamping or hot pressing.

It should be noted that, the inventors of this application find through research that, if the first cover plate 10 including only the first material layer 12 is directly disposed, where the material of the first material layer 12 includes an organic polymer material, the weight can be reduced; however, the organic polymer material includes organic macromolecules, and the material itself has relatively large pores. Therefore, long-term air tightness cannot be ensured by directly using the first cover plate 10 made of the organic polymer material, and a problem of vapor leakage may occur. In addition, because the organic polymer material is in direct contact with the working fluid (for example, water) inside the receptacle 50, the organic polymer material is prone to chemical reactions that generate non-condensable gas. The non-condensable gas may accumulate in a condensing area of the receptacle 50, resulting in degradation of thermal uniformity and heat dissipation performance of the VC. In this embodiment of this application, the first material layer 12 is sandwiched between the first sealing layer 11 and the second sealing layer 13. On one hand, the total weight of the first cover plate 10 can be effectively reduced, and a lightweight design can be achieved. On the other hand, the first material layer 12 can be well sealed and protected, thereby prolonging the service life of the first cover plate 10 and enhancing the reliability of the first cover plate 10.

In addition, in some examples, the material of the first material layer 12 in the first cover plate 10 is an organic polymer material (for example, PI), and materials of the first sealing layer 11 and the second sealing layer 13 are both metal (for example, copper). The organic polymer material has a relatively low elastic modulus, a relatively high elongation rate, and relatively good toughness, but has a relatively low structural strength after plastic deformation. Therefore, it is prone to deformation. The metal has a relatively high elastic modulus and a relatively low elongation rate, and still has relatively high structural strength and hardness after plastic deformation. Therefore, the metal is not prone to deformation. In this embodiment of this application, the first cover plate 10 including the buffer grooves 70 and the protruding structures 71 may be formed by a composite material of the first sealing layer 11, the first material layer 12, and the second sealing layer 13 by using a plastic molding process (including cold pressing, hot pressing, or the like). The first cover plate 10, integrating advantages of the organic polymer material such as a high elongation rate and good toughness with high strength of the metal, has an excellent buffering function, so that the screen 1001 can be protected.

For example, a percentage of a thickness (a size along the Z2 axis direction) of the first material layer 12 to a total thickness (a size along the Z2 axis direction) of the first cover plate 10 is greater than or equal to 20%. With this configuration, the first cover plate 10 achieves relatively good lightweight benefits. In addition, when the buffer grooves 70 and the protruding structures 71 are formed on the first cover plate 10 through compression molding, problems of wrinkling or even fracturing are not likely to occur.

For example, a percentage of a thickness (a size along the Z2 axis direction) of the first material layer 12 to a total thickness (a size along the Z2 axis direction) of the first cover plate 10 is greater than or equal to 24%. With this configuration, lightweight benefits of the first cover plate 10 are more significant. In addition, when the buffer grooves 70 and the protruding structures 71 are formed on the first cover plate 10 through compression molding, problems of wrinkling or even fracturing are not likely to occur.

For example, a percentage of a thickness (a size along the Z2 axis direction) of the first material layer 12 to a total thickness (a size along the Z2 axis direction) of the first cover plate 10 is greater than or equal to 33%. With this configuration, lightweight benefits of the first cover plate 10 are more significant. In addition, when the buffer grooves 70 and the protruding structures 71 are formed on the first cover plate 10 through compression molding, problems of wrinkling or even fracturing are not likely to occur.

For example, a thickness (a size along the Z2 axis direction) of the first material layer 12 is greater than or equal to 5 µm. With this configuration, the first cover plate 10 achieves relatively good lightweight benefits. In addition, when the plurality of protruding structures 71 are formed on the first cover plate 10 through compression molding, problems of wrinkling or even fracturing are not likely to occur.

For example, a thickness of the first material layer 12 is greater than or equal to 15 µm. With this configuration, lightweight benefits of the first cover plate 10 are more significant. In addition, when the buffer grooves 70 and the protruding structures 71 are formed on the first cover plate 10 through compression molding, problems of wrinkling or even fracturing are not likely to occur.

It should be noted that an existing three-layer composite flexible copper clad laminate (Flexible Copper Clad Laminate, FCCL) includes an intermediate substrate (for example, PI) and copper layers on both sides, and a thickness of the copper layer does not exceed 0.05 mm. In some examples, the existing three-layer composite flexible copper clad laminate may be directly used to form the buffer grooves 70 and the protruding structures 71 through compression molding, thereby forming the first cover plate 10, and there is no need to customize a special thickness specification for a raw material. This is more conducive to reducing costs of the raw material. Therefore, a low-cost and lightweight first cover plate 10 that is easy to mass-produce can be provided. For example, in the three-layer composite flexible copper clad laminate, thicknesses of upper and lower copper layers may be 12 µm, and a thickness of a middle layer may be 25 µm.

Table 1 shows density values of several raw materials used for preparing the first cover plate (or the second cover plate) in this embodiment of this application.

**Table 1**

| Raw material | Model | Density [kg/m³] |
|---|---|---|
| Copper alloy | C5191 | 8960 |
| Stainless steel | 316L | 7874 |
| Titanium alloy | TA1 | 4506 |
| Polyimide (PI) | - | 1880 |
| FCCL (two layers or three layers) | A percentage of PI is greater than or equal to 30% | 3000 to 6000 |

It can be learned from Table 1 that, in this application, when the first cover plate 10 is formed by using the three-layer composite flexible copper clad laminate (Flexible Copper Clad Laminate, FCCL), the first cover plate 10 has a lower average density (that is, 3000 to 6000), making a lightweight design more easily achievable.

The following describes the second cover plate 20 provided in some embodiments of this application.

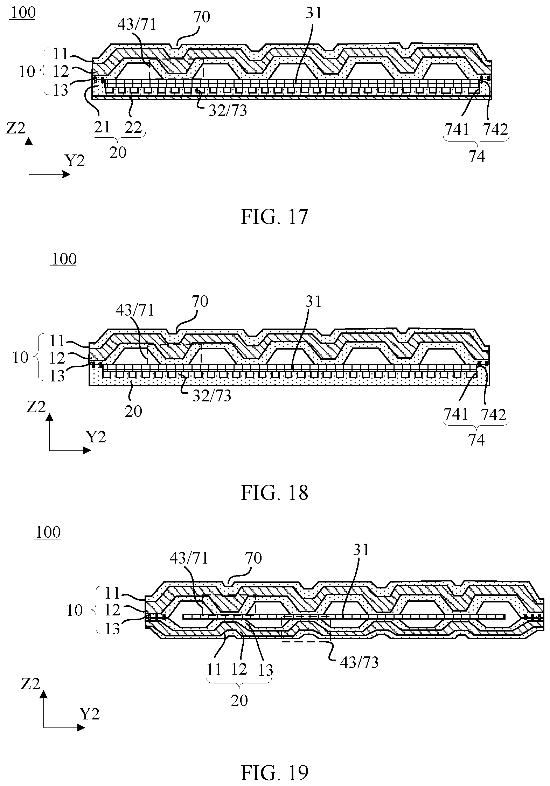

Refer to FIG. 16 and FIG. 17. FIG. 16 is a diagram of a structure of a heat dissipation structure according to an embodiment of this application. FIG. 17 is a diagram of a structure of another heat dissipation structure according to an embodiment of this application. A difference between FIG. 16 and FIG. 17 lies in a structure of the second cover plate. In some embodiments, the second cover plate 20 includes a third sealing layer 21 and a second material layer 22; the second material layer 22 is located on one side that is of the third sealing layer 21 and that is away from the first cover plate 10; and yield strain of the second material layer 22 is greater than yield strain of the third sealing layer 21.

In this embodiment, the yield strain of the second material layer 22 is set to be greater than the yield strain of the third sealing layer 21. This helps improve structural strength of the second cover plate 20, so that the second cover plate 20 is not prone to cracking. For example, when structures such as micro-pillars 32 and/or support pillars 43 are etched on a surface of one side that is of the third sealing layer 21 and that is away from the second material layer 22, a substrate of the third sealing layer 21 may be etched to a thickness of 0.03 mm or less without wrinkles or cracks. In addition, a unit weight of the second material layer 22 may be less than a unit weight of the third sealing layer 21. Therefore, compared with a second cover plate of a same thickness but without the second material layer 22, a total weight of the second cover plate 20 can be further reduced, and a lightweight design can be achieved.

For example, in the heat dissipation structure 100 provided in some embodiments of this application, a designed thickness of the first cover plate 10 may be not less than 0.03 mm, a designed thickness of the liquid-absorbing core 31 may be not less than 0.14 mm, and a designed thickness of the second cover plate 20 may be not less than 0.03 mm. In this case, a total thickness of the heat dissipation structure 100 may be at least 0.2 mm, and the structure is very thin. In some examples, a designed thickness of the first cover plate 10 is 0.05 mm, a designed thickness of the liquid-absorbing core 31 is 0.15 mm, and a designed thickness of the second cover plate 20 is 0.05 mm. In this case, a total thickness of the heat dissipation structure is 0.25 mm. In this example, the heat dissipation structure 100 is relatively thin in thickness, and lightweight benefits are significant. It may be understood that, in the embodiments in FIG. 16 and FIG. 17, because the liquid-absorbing core 31 is located in the second cover plate 20, in this case, an actual thickness of the second cover plate 20 is the designed thickness of the second cover plate plus the designed thickness of the liquid-absorbing core 31. The total thickness of the heat dissipation structure 100 is the actual thickness of the second cover plate 20 plus the designed thickness of the first cover plate 10. Each "thickness" herein refers to a size along the Z2 axis direction.

For example, a material of the third sealing layer 21 may include metal or ceramic. The metal may be pure copper, a copper alloy, or the like. In this example, the third sealing layer 21 has relatively high structural strength, and has relatively good sealing performance and toughness. This helps improve the structural strength of the second cover plate 20 and prolong service life of the second cover plate 20.

For example, the second sealing layer 13 is closer to the third sealing layer 21 than the first sealing layer 11; and the material of the third sealing layer 21 is the same as the material of the second sealing layer 13. This configuration facilitates welding and sealing of the third sealing layer 21 and the second sealing layer 13, that is, facilitates welding and fastening of the first cover plate 10 and the second cover plate 20.

For example, a material of the second material layer 22 includes an organic polymer material, for example, polyimide (polyimide, PI), polypropylene (polypropylene, PP), polytetrafluoroethylene (polytetrafluoroethylene, PTFE), polyethylene terephthalate (polyethylene terephthalate, PET), polyethylene naphthalate (polyethylene naphthalate, PEN), polydimethylsiloxane (polydimethylsiloxane, PDMS), polyethylene (polyethylene, PE), polypropylene carbonate (polypropylene carbonate, PPC), polyviny chloride (polyviny chloride, PVC), polyvinylidene chloride (polyvinylidene chloride, PVdC), polystyrene (polystyrene, PS), polyamide (polyamide, PA), or the like.

In this example, the second material layer 22 may have relatively good toughness, so that the formed second cover plate 20 has relatively high structural strength and that problems of wrinkling or even fracturing are not likely to occur.

For example, a percentage of a thickness (a size along the Z2 axis direction) of the second material layer 22 to a total thickness (a size along the Z2 axis direction) of the second cover plate 20 is greater than or equal to 50%. With this configuration, the second cover plate 20 achieves relatively good lightweight benefits. In addition, when structures such as the micro-pillars 32 and/or the support pillars 43 are etched on the second cover plate 20, problems of wrinkling or even fracturing are not likely to occur.

In some examples, as shown in FIG. 16, the second cover plate 20 has a placement groove 72 formed through compression molding on one side close to the first cover plate 10, and the liquid-absorbing core 31 is placed in the placement groove 72. In this case, the micro-pillars 32 may not be disposed on the second cover plate 20.

In this example, the second cover plate 20 has the second material layer 22 with better toughness, and an area of the placement groove 72 formed through compression molding on the side that is of the second cover plate 20 and that is close to the first cover plate 10 is relatively large. Therefore, the structural strength of the second cover plate 20 is still relatively high, and problems of wrinkling or even fracturing are not likely to occur.

It should be noted that an existing two-layer composite flexible copper clad laminate (Flexible Copper Clad Laminate, FCCL) includes a substrate (for example, PI) and a copper layer on the substrate side, and that a thickness of the copper layer does not exceed 0.05 mm. In some examples, the existing two-layer composite flexible copper clad laminate may be directly used to form the placement groove 72 through compression molding, thereby forming the second cover plate 20, and there is no need to customize a special thickness specification for a raw material. This is more conducive to reducing costs of the raw material. Therefore, a low-cost and lightweight second cover plate 20 that is easy to mass-produce can be provided.

It can be learned from the foregoing Table 2 that, in this application, when the second cover plate 20 is formed by using the two-layer composite flexible copper clad laminate (Flexible Copper Clad Laminate, FCCL), the second cover plate 20 has a lower average density (that is, 3000 to 6000), making a lightweight design more easily achievable.

In some other examples, as shown in FIG. 17, the third sealing layer 21 has a groove 74 on one side close to the first cover plate 10, the groove 74 includes a first groove part 741 and a second groove part 742, and the first groove part 741 is closer to a bottom wall of the groove 74 than the second groove part 742. The second cover plate 20 further includes a plurality of pillar structures 73 located in the first groove part 741, and the plurality of pillar structures 73 are connected to the bottom wall. The liquid-absorbing core 31 is placed in the second groove part 742. The plurality of pillar structures 73 support the liquid-absorbing core 31.

For example, the pillar structures 73 herein may be the foregoing support pillars 43 or the foregoing micro-pillars 32.

For example, the pillar structures 73 may be processed by using a process such as stamping, hot pressing, etching, or electroplating.

In this solution, because the second cover plate 20 has the second material layer 22 with better toughness, the groove 74 located at the third sealing layer 21 may be formed through compression molding or etching. Regardless of the formation manner, the structural strength of the formed second cover plate 20 is still relatively high. In addition, when the groove 74 is formed through etching, the plurality of pillar structures 73 in the groove 74 may also be directly formed through etching. When the groove 74 is formed through compression molding, the plurality of pillar structures 73 in the groove 74 may be formed through glue dispensing. This configuration helps ensure that the second cover plate 20 has sufficient structural strength.

In some other embodiments, refer to FIG. 18. FIG. 18 is a diagram of a structure of still another heat dissipation structure 100 according to an embodiment of this application. A second cover plate 20 in the heat dissipation structure 100 is formed through etching by using a metal material such as pure copper or a copper alloy. In this case, a thickness of a substrate of the second cover plate 20 may be greater than 0.03 mm. With this configuration, wrinkling, cracking, and deformation are not likely to occur.

On this basis, for example, as shown in FIG. 18, a groove 74 including a first groove part 741 and a second groove part 742 may be further disposed on the second cover plate 20, and a plurality of pillar structures 73 and a liquid-absorbing core 31 are disposed in the groove 74. For a specific disposition manner, refer to the foregoing content. Details are not described herein again.

In still some other embodiments, a manner of disposing the second cover plate 20 may be the same as a manner of disposing the first cover plate 10. Details are not described herein again. To be specific, FIG. 19 is a diagram of a structure of still another heat dissipation structure 100 according to an embodiment of this application.

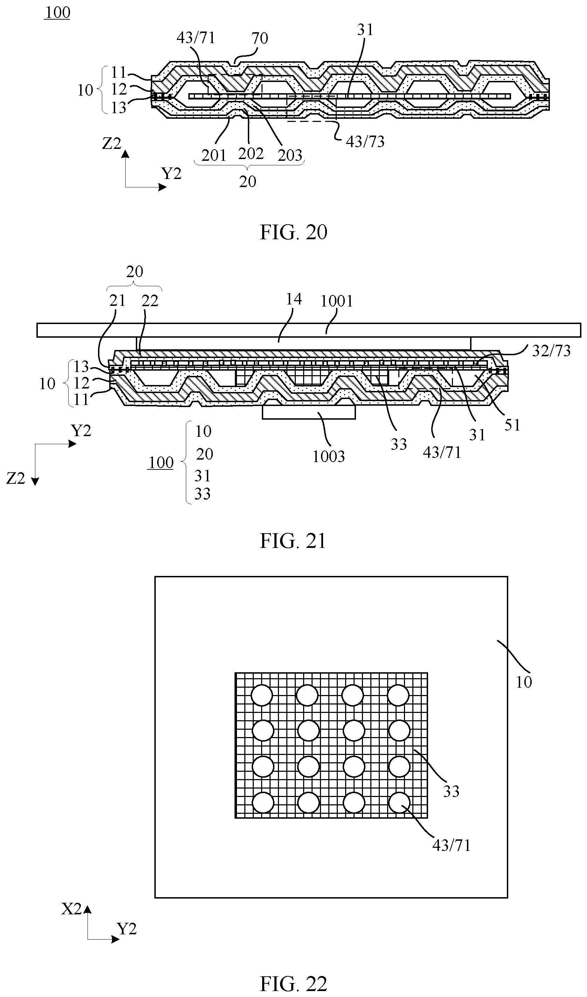

In still some other embodiments, refer to FIG. 20. FIG. 20 is a diagram of a structure of still another heat dissipation structure 100 according to an embodiment of this application. A material of a second cover plate 20 of the heat dissipation structure 100 may be a two-layer/three-layer metal composite material (for example, a first metal layer 201, a second metal layer 202, and a third metal layer 203), for example, copper-steel, copper-titanium, copper-steel-copper, copper-titanium-copper, copper-aluminum-copper, copper-magnesium-copper, and copper-(magnesium-aluminum alloy)-copper. The composite material has relatively high strength. This can greatly improve overall mechanical structural performance of the heat dissipation structure 100, prevent deformation of the heat dissipation structure 100 under compression, increase a manufacturing yield rate of the heat dissipation structure 100, and improve overall reliability of the electronic device. In addition, it should be noted that the two-layer/three-layer metal composite material provided in this embodiment of this application is more applicable to a low-temperature (for example, 300 to 400 degrees Celsius) process used for the first cover plate 10. In other words, after the second cover plate 20 is formed, the second cover plate 20 is not likely to soften, and can have higher structural strength.

On this basis, for example, a plurality of pillar structures 73 may be formed on the second cover plate 20 through compression by using a shaping process such as stamping or hot pressing. In this case, the pillar structures 73 are equivalent to support pillars 43, and a vapor channel is formed between the plurality of pillar structures 73. The pillar structures 73 can enable the heat dissipation structure 100 to have higher structural strength. Therefore, the heat dissipation structure 100 is not likely to collapse and block the vapor channel, the heat dissipation structure 100 is not likely to fail, and reliability is higher.

The first cover plate 10, the second cover plate 20, and the liquid-absorbing core 31 (hereinafter referred to as a first liquid-absorbing core) are described above. The following describes a second liquid-absorbing core and a third liquid-absorbing core.

In some embodiments, refer to FIG. 21 and FIG. 22. FIG. 21 is a diagram of a structure of a heat dissipation structure 100 cooperating with a screen 1001 and a heat emitting component 1003 according to an embodiment of this application, and FIG. 22 is a diagram of a combination of a first cover plate 10 and a second liquid-absorbing core 33 according to an embodiment of this application. An adhesive layer 14 may be located on one side that is of a second cover plate 20 and that is away from the first cover plate 10, that is, the adhesive layer 14 is bonded between the second cover plate 20 and the screen 1001. Micro-pillars 32 and a first liquid-absorbing core (that is, a liquid-absorbing core 31) are disposed in the second cover plate 20. In addition, the second liquid-absorbing core 33 is further disposed in a vapor channel 51 between the second cover plate 20 and the first cover plate 10. A surface of one side of the second liquid-absorbing core 33 is in contact with the first cover plate 10, and a surface of the other side of the second liquid-absorbing core 33 is in contact with the first liquid-absorbing core. An orthographic projection of the heat emitting component 1003 in an X2-Y2 plane at least partially overlaps an orthographic projection of the second liquid-absorbing core 33 in the X2-Y2 plane. For example, the orthographic projection of the heat emitting component 1003 in the X2-Y2 plane may be located in the orthographic projection of the second liquid-absorbing core 33 in the X2-Y2 plane. With this configuration, heat of the heat emitting component 1003 can be directly transferred to the second liquid-absorbing core 33 through the first cover plate 10, and then transferred to the first liquid-absorbing core through the second liquid-absorbing core 33. Compared with heat transfer through the vapor channel 51 to the first liquid-absorbing core, thermal resistance is lower, and thermal uniformity is better.

With reference to FIG. 22, it can be learned that the second liquid-absorbing core 33 may expose a support pillar 43 on the first cover plate 10, that is, the second liquid-absorbing core 33 may have a through hole that extends along a Z2 direction, allowing the support pillar 43 to pass through the through hole.

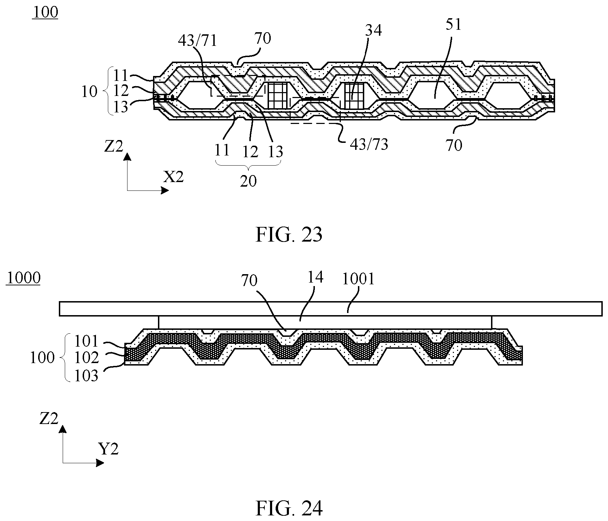

In some embodiments, refer to FIG. 23. FIG. 23 is a diagram of a structure of still another heat dissipation structure 100 according to an embodiment of this application. A difference between FIG. 23 and FIG. 19 lies in that the serially disposed first liquid-absorbing core is replaced with third liquid-absorbing cores 34 disposed in parallel. The first liquid-absorbing core may be considered as a serial capillary solution. In the embodiment in FIG. 23, a plurality of third liquid-absorbing cores 34 may be disposed. Each third liquid-absorbing core 34 is in contact with the first cover plate 10 and the second cover plate 20 respectively along two opposite surfaces in a Z2 axis direction, and the plurality of third liquid-absorbing cores may be spaced apart along an X2 direction.

Materials and structures of the second liquid-absorbing core 33 and the third liquid-absorbing core 34 may be the same as those of the liquid-absorbing core 31, and details are not described herein again.

An embodiment of this application further provides a method for preparing a heat dissipation structure 100. Specifically, S1: Select appropriate raw materials for cover plates. S2: Perform processing such as stamping, cutting, and etching on the raw materials of the cover plates to form the first cover plate 10 and the second cover plate 20 described above. S3: Weld and fasten a liquid-absorbing core 31 and the second cover plate 20 (for example, a welding temperature is lower than 300 degrees). S4: Weld or bond a conduit (not shown in the figure) between the first cover plate 10 and the second cover plate 20, and weld and fasten an edge of the first cover plate 10 and an edge of the second cover plate 20 (for example, the edge of the second sealing layer 13 and the edge of the third sealing layer 21 described above may be welded and fastened). S5: Detect whether liquid leaks between the first cover plate 10 and the second cover plate 20 after the welding. S6: Through a reduction reaction (for example, a reduction reaction at a high temperature, about 300 degrees), change surfaces of the liquid-absorbing core 31 and micro-pillars 32 from hydrophobic surfaces to hydrophilic surfaces, for example, change materials of the liquid-absorbing core 31 and the micro-pillars 32 from copper oxide to copper, so that the liquid-absorbing core 31 and the micro-pillars 32 are capable of capillary water absorption. S7: Inject a working fluid into a receptacle through the conduit, and create a vacuum. S8: Cut the conduit and seal the receptacle to form a sealed receptacle. S9: Perform an aging test, for example, place the heat dissipation structure in a high-temperature chamber for predetermined duration. S10: Perform a sealing inspection (for example, a helium leak detection) on the heat dissipation structure. S11: Perform other performance tests, such as testing thermal conductivity of the heat dissipation structure.

For example, glassification temperatures Td of a first material layer 12 and a second material layer 22 are higher than or equal to 320 degrees. With this configuration, in a process of preparing the first cover plate 10 and the second cover plate 20, the first material layer 12 and the second material layer 22 can maintain good physical performance.

An embodiment of this application further provides another heat dissipation structure 100. Refer to FIG. 24. FIG. 24 is a diagram of a structure of another heat dissipation structure 100 cooperating with a screen 1001 according to an embodiment of this application. The heat dissipation structure 100 includes a fourth sealing layer 101, a third material layer 102, and a fifth sealing layer 103, where in a first direction (Z2 axis direction), the third material layer 102 is located between the fourth sealing layer 101 and the fifth sealing layer 103; a material of the third material layer 102 includes at least one of a graphite material and a graphene material; the heat dissipation structure 100 has a plurality of buffer grooves 70 spaced apart; and positions that are in the third material layer 102 and that correspond to the buffer grooves 70 include elastic deformation and/or plastic deformation.

In the another heat dissipation structure provided in this embodiment of this application, because the material of the third material layer 102 includes at least one of the graphite material and the graphene material, and the positions that are in the third material layer 102 and that correspond to the buffer grooves 70 include elastic deformation and/or plastic deformation, the heat dissipation structure 100 achieves good heat dissipation effect and thermal uniformity, and in particular, a heat accumulation phenomenon is not likely to occur at the positions corresponding to the buffer grooves 70 in the heat dissipation structure 100. In addition, because the fourth sealing layer 101 and the fifth sealing layer 103 are respectively provided on two opposite sides of the third material layer 102, on one hand, the third material layer 102 can be sealed and protected well. Therefore, the third material layer 102 is not likely to collapse. This can not only provide excellent buffering and supporting for the screen 1001, and prevent failure problems on the screen 1001, such as shadows, dark spots, imprints, bright spots, green lines, or shattering, but also prevent thermal uniformity and heat dissipation capabilities of the heat dissipation structure 100 from weakening due to the collapse of the third material layer 102, thereby prolonging service life of the heat dissipation structure 100 and enhancing reliability of the heat dissipation structure 100. On the other hand, because a relatively symmetric structure can be formed, flatness of the heat dissipation structure 100 can be better. For example, because mechanical material parameters such as a modulus of a material in a thickness direction of the heat dissipation structure 100 are more symmetric, the heat dissipation structure 100 is not prone to warping. In addition, the third material layer 102 is lighter in weight, and this helps reduce a total weight of the heat dissipation structure 100 and achieve a lightweight design.

In some embodiments, thermal conductivity of the third material layer 102 is greater than or equal to 400 W/(m·k). This configuration enables the heat dissipation structure 100 to have relatively high thermal conduction efficiency.

In some embodiments, a material of at least one of the fourth sealing layer 101 and the fifth sealing layer 103 includes copper. With this configuration, the third material layer 102 can be better sealed and protected, and heat dissipation efficiency is relatively high.

With continued reference to FIG. 24, an adhesive layer 14 may also be added between the heat dissipation structure 100 and the screen 1001. Because the adhesive layer 14 is disposed, the heat dissipation structure 100 can be bonded and fastened to the screen 1001. In addition, when the heat dissipation structure 100 is bonded and fastened to the screen 1001, because the heat dissipation structure 100 has the buffer grooves 70, the buffer grooves 70 can be further used to prevent a problem that the adhesive layer between the screen and the heat dissipation structure 100 detaches and fails due to shear stress.

In addition, for a manner of arranging the buffer grooves 70 in the heat dissipation structure 100 in the embodiment in FIG. 24, refer to the description of the buffer grooves 70 on the first cover plate 10. Details are not described herein again. In addition, the buffer grooves 70 herein may also be filled with the first filler 44 and/or the second filler 45.

In summary, the heat dissipation structure provided in the embodiments of this application has at least the following advantages:
1. The buffer grooves 70 are provided in the first cover plate 10, the positions that are in the first material layer 12 and that correspond to the buffer grooves 70 include elastic deformation, and the buffer grooves 70 can absorb stress. Therefore, the first cover plate 10 is more flexible and does not have excessive rebound force. In other words, failure problems such as shadows, dark spots, imprints, bright spots, green lines, or shattering caused by excessive rebound force are not likely to occur on the screen 1001.
2. Because the material of the third material layer 102 includes at least one of the graphite material and the graphene material, and the positions that are in the third material layer 102 and that correspond to the buffer grooves 70 include elastic deformation and/or plastic deformation, the formed heat dissipation structure 100 achieves good heat dissipation effect and thermal uniformity, and in particular, a heat accumulation phenomenon is not likely to occur at the positions corresponding to the buffer grooves 70 in the heat dissipation structure 100. In addition, the screen can be protected, and a lightweight design can be achieved.
3. The first filler 44 and/or the second filler 45 are/is disposed in the buffer grooves. This helps further improve the thermal conduction capability and the buffering protection capability of the first cover plate 10.
4. When the first cover plate 10 includes the first material layer 12, the average density of the first cover plate 10 is low, and this helps reduce the weight of the first cover plate 10. When the second cover plate 20 includes the second material layer 22, the average density of the second cover plate 20 is low, and this helps reduce the weight of the second cover plate 20.
5. The first cover plate 10 may be directly formed through compression molding by using the three-layer composite flexible copper clad laminate FCCL, and the second cover plate 20 may be directly formed through compression molding by using the two-layer composite flexible copper clad laminate FCCL. In this way, the costs of the raw material can be reduced, and mass production of the cover plates is easier.
6. For a heat dissipation structure housing made of a copper alloy material, a heat dissipation structure housing made of a stainless steel material, and a heat dissipation structure housing made of a titanium alloy material, a maximum temperature in the process is approximately 800°C (annealing and sintering). However, in the embodiments of this application, for the heat dissipation structure 100 including the first material layer 12 and/or the second material layer 22, a maximum temperature throughout the process is about 300°C. This can help maintain relatively good yield strength and fracture strength of materials of metal layers such as the copper layer, so that the heat dissipation structure 100 is not prone to wrinkling, deformation, or cracking when subjected to compression or impact.
7. Because the first cover plate 10 in the heat dissipation structure 100 may include an insulation first material layer 12 (for example, PI), and the second cover plate 20 may include an insulation second material layer 22 (for example, PI), the heat dissipation structure 100 can be fully or partially insulated on one side facing the middle frame. This prevents a problem of radiated spurious emission (Radiated spurious emission, RSE) of heat from the heat dissipation structure 100.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation structure, comprising a first cover plate, a second cover plate, and a liquid-absorbing structure, wherein the first cover plate and the second cover plate are connected to each other to form a receptacle; and the liquid-absorbing structure is located in the receptacle;
the heat dissipation structure has a first area and a second area; the liquid-absorbing structure extends from the first area to the second area; and the receptacle further has a vapor channel, and the vapor channel extends from the second area to the first area; and
the first cover plate comprises a first sealing layer, a first material layer, and a second sealing layer; the first material layer is located between the first sealing layer and the second sealing layer; the first cover plate has a plurality of buffer grooves spaced apart; and positions that are in the first material layer and that correspond to the buffer grooves comprise elastic deformation.

2. The heat dissipation structure according to claim 1, wherein
yield strain of the first material layer is greater than yield strain of the first sealing layer and greater than yield strain of the second sealing layer; and positions that are in the first sealing layer and the second sealing layer and that correspond to the buffer grooves comprise plastic deformation.

3. The heat dissipation structure according to claim 1 or 2, wherein
top openings of at least some buffer grooves face one side that is of the first cover plate and that is away from the second cover plate.

4. The heat dissipation structure according to any one of claims 1 to 3, wherein
a shape of any buffer groove comprises any one of a circle, a polygon, a bar, and a wave strip.

5. The heat dissipation structure according to any one of claims 1 to 4, wherein the first cover plate further comprises:
a first filler, located in at least one of the buffer grooves, wherein a material of the first filler comprises an organic polymer material.

6. The heat dissipation structure according to any one of claims 1 to 5, wherein the first cover plate further comprises:
a second filler, located in at least one of the buffer grooves, wherein a material of the second filler comprises a phase-change energy storage material.

7. The heat dissipation structure according to any one of claims 1 to 6, wherein
a percentage of a thickness of the first material layer to a total thickness of the first cover plate is greater than or equal to 20%.

8. The heat dissipation structure according to any one of claims 1 to 7, wherein
a thickness of the first sealing layer is equal to or basically equal to a thickness of the second sealing layer.

9. The heat dissipation structure according to any one of claims 1 to 8, wherein
a material of the first material layer comprises an organic polymer material; and
a material of at least one of the first sealing layer and the second sealing layer comprises at least one of metal and ceramic.

10. The heat dissipation structure according to any one of claims 1 to 9, wherein
the second cover plate comprises a third sealing layer and a second material layer; the second material layer is located on one side that is of the third sealing layer and that is away from the first cover plate; and yield strain of the second material layer is greater than yield strain of the third sealing layer.

11. The heat dissipation structure according to claim 10, wherein
a material of the second material layer comprises an organic polymer material; and
a material of the third sealing layer comprises at least one of metal and ceramic.

12. The heat dissipation structure according to claim 10 or 11, wherein
the second sealing layer is closer to the third sealing layer than the first sealing layer; and
the material of the third sealing layer is the same as the material of the second sealing layer.

13. The heat dissipation structure according to any one of claims 10 to 12, wherein
the third sealing layer has a groove on one side close to the first cover plate, the groove comprises a first groove part and a second groove part, and the first groove part is closer to a bottom wall of the groove than the second groove part; and
the second cover plate further comprises a plurality of pillar structures located in the first groove part, and the plurality of pillar structures are connected to the bottom wall; the liquid-absorbing structure comprises a liquid-absorbing core, and the liquid-absorbing core is placed in the second groove part; and the plurality of pillar structures support the liquid-absorbing core.

14. The heat dissipation structure according to claim 9 or 11, wherein
the organic polymer material comprises at least one of PI, PP, PTFE, PET, PEN, PDMS, PE, PPC, PVC, PVdC, PS, and PA; and
the metal comprises copper.

15. The heat dissipation structure according to any one of claims 1 to 14, wherein
the second cover plate has a compression-molded placement groove on one side close to the first cover plate, the liquid-absorbing structure comprises the liquid-absorbing core, and the liquid-absorbing core is placed in the placement groove.

16. The heat dissipation structure according to any one of claims 1 to 9, wherein the second cover plate comprises at least two stacked metal layers.

17. The heat dissipation structure according to claim 16, wherein the at least two metal layers comprise any one of copper-steel, copper-titanium, copper-steel-copper, copper-titanium-copper, copper-aluminum-copper, copper-magnesium-copper, and copper-(magnesium-aluminum alloy)-copper.

18. A heat dissipation structure, comprising a fourth sealing layer, a third material layer, and a fifth sealing layer, wherein in a first direction, the third material layer is located between the fourth sealing layer and the fifth sealing layer; a material of the third material layer comprises at least one of a graphite material and a graphene material; the heat dissipation structure has a plurality of buffer grooves spaced apart; and positions that are in the third material layer and that correspond to the buffer grooves comprise elastic deformation and/or plastic deformation.

19. The heat dissipation structure according to claim 18, wherein
thermal conductivity of the third material layer is greater than or equal to 400 W/(m·k).

20. The heat dissipation structure according to claim 18 or 19, wherein
a material of at least one of the fourth sealing layer and the fifth sealing layer comprises copper.

21. An electronic device, comprising:
a screen and a heat emitting component; and
the heat dissipation structure according to any one of claims 1 to 20, located between the screen and the heat emitting component.

22. The electronic device according to claim 21, comprising:
an adhesive layer, located between the heat dissipation structure and the screen.
